# EUROPÄISCHE PATENTSCHRIFT

(11) **EP 1 867 121 B1**
(45) Veröffentlichungstag und Bekanntmachung des Hinweises auf die Patenterteilung: **11.02.2009**
(21) Anmeldenummer: 06723964.0
(22) Anmeldetag: 03.04.2006
(51) Int. Cl.: H04L 27/08, H03G 3/30

(54) **Demodulations- und Verstärkungsregelkonzept, insbesondere für IR-Empfänger**
Demodulation and amplification regulation concept, in particular for IR receivers
Concept de démodulation et d'amplification, notamment pour récepteurs IR

(30) Priorität: 07.04.2005 DE 102005017004
(43) Veröffentlichungstag der Anmeldung: 19.12.2007
(73) Patentinhaber: ATMEL Germany GmbH, 74072 Heilbronn (DE)
(72) Erfinder: KURZ, Alexander, 74523 Schwäbisch Hall (DE)
(74) Vertreter: Müller, Wolf-Christian
(86) Internationale Anmeldenummer: PCT/EP2006/003005
(87) Internationale Veröffentlichungsnummer: WO 2006/105921

(56) Entgegenhaltungen:
- US-A- 4 339 728
- PATENT ABSTRACTS OF JAPAN Bd. 2003, Nr. 09, 3. September 2003 (2003-09-03) & JP 2003 152649 A (SONY CORP), 23. Mai 2003 (2003-05-23)

## Beschreibung

*Die Erfindung betrifft ein Verfahren zur Verstärkung und Demodulation amplitudenmodulierter Signale (10). In ihrem Vorrichtungsaspekt betrifft die Erfindung einen amplitudenmodulierte Signale verarbeitenden Schaltkreis.*

Infrarot (IR) Receiver Module bestehen üblicherweise aus einem monolithischen Schaltkreis und einer externen Photodiode. Das empfangene Infrarotsignal wird verstärkt, gefiltert, demoduliert und als elektrisches Signal am Ausgang bereitgestellt. Durch die intern vorhandene Regelung wird der Schaltkreis an die Umgebungsbedingungen angepasst. Die Umgebungsbedingungen werden z.B. durch die Helligkeit der Umgebung, gegebenenfalls durch Störstrahlung von Neon-Röhren im IR-Frequenzbereich und der Entfernung eines Datensenders beeinflusst. Typische Datensender sind z.B. mobile Teile einer TV-Fernbedienung. Bei der bekannten Regelung ist der Signalschwellenwert größer als der Regelschwellenwert.

So führen Datenprotokolle mit hoher Datenrate und geringen Burstpausen im Protokoll zu einer häufigen Überschreitung des Regelschwellenwertes, der daraufhin die Verstärkung verringert. Als Folge kann es passieren, dass der kleinere Signalschwellenwert nicht mehr erreicht wird. Im Ergebnis werden diese Datenprotokolle damit gewissermaßen als Störung interpretiert und unterdrückt.

Ein sich annähernder Datensender mit höherer Datenrate hat unter Umständen eine ähnliche Reaktion der Regelung zur Folge. Auch dann können Daten des Datensenders nicht mehr demoduliert werden, weil die Regelung, getriggert durch den Regelschwellenwert, den Datensender als Störungsquelle interpretiert und die Verstärkung des Systems reduziert.

Außerdem sind die bekannten Regelverfahren vergleichsweise träge, so dass das Ausgangssignal des Schaltkreises bei stark schwankender Eingangsdatensignalstärke unerwünscht starke Schwankungen (Jitter, Ausgangspulsstreuungen) aufweist. Die Eingangsdatensignalstärke kann z.B. bei handelsüblichen IR-Fernbedienungen schwanken, weil diese über Entfernungen zwischen einem Zentimeter und etwa 35 Metern einsetzbar sein sollen, was bei deren konstanter Abstrahlungsleistung zu den genannten, erheblichen Signalstärkeschwankungen am Eingang des Receiver-Moduls führt.

Vor diesem Hintergrund besteht die Aufgabe der Erfindung in der Angabe eines Verfahrens und eines Schaltkreises, bei denen *insbesondere* Datenprotokolle mit hoher Datenrate und geringen Burstpausen im Protokoll nicht unterdrückt werden, bei denen *insbesondere* die Gefahr eines Ausfalls der Erkennung von Daten eines sich annähernden Datensenders, der mit höherer Datenrate sendet, verringert wird, und bei denen *insbesondere* eingehende Impulse, die zum Beispiel aufgrund variabler Entfernung des Datensenders stark schwankende Eingangssignalstärken aufweisen, erkannt werden können, wobei die von dem Verfahren und dem Schaltkreis erzeugten Ausgangspulssignalamplituden insbesondere durch eine schnelle Anpassung an die Eingangssignalstärke weitgehend konstant gehalten werden können.

*In der* US 4,339,728 *sind ein Signalverstärker und eine automatische Verstärkungsregelung für einen Radioempfänger bekannt. Dabei sind ein Paar von Stromspiegeln mit einem Differenzverstärker gekoppelt um ein Ausgangssignal abzugeben. Ein erstes Ausgangssignal wird zu automatischen Verstärkungsregelung verwendet, ein zweites Ausgangssignal wird zur Signaldetektion verwendet. Die Stromspiegel sind so eingestellt, dass die Schwelle für die automatische Verstärkungsregelung ein Vielfaches der Signaldetektionsschwelle ist.*

*Diese Aufgabe wird sowohl bei einem Verfahren als auch bei einem Schaltkreis der jeweils eingangs genannten Art gelöst.*

*Dabei weist der Schritt der Demodulation Schritte einer digitalen Filterung mit Diskrimination und Integrationsschritte auf. Der Demodulator des Schaltkreises weist ein Digitalfilter mit einem Diskriminator und einen Integrator auf.*

*Der Signalschwellenwert ist zudem kleiner als der Regelschwellenwert.* Die vorteilhafte Wirkung dieses Merkmals wird an dem folgenden Beispiel deutlich. Betrachtet wird ein Primärsignal mit hoher Datenrate und damit nur kleinen Pausen zwischen einzelnen Bursts (Burst = schnelle Folge von z.B. 6 bis 30 Einzelpulsen) in einer rauschfreien Umgebung. Sowohl beim Stand der Technik als auch bei der Erfindung erfolgt das Regeln der Verstärkung des Primärsignals so, dass sich Spitzenwerte des gefilterten Signals dem Regelschwellenwert annähern. Beim Stand der Technik führt dies dazu, dass die Signalstärke unter den größeren Signalschwellenwert geregelt wird, so dass aus dem Vergleich mit diesem Schwellenwert keine Daten mehr ableitbar sind. Bei der Erfindung ist dagegen der Signalschwellenwert kleiner als der Regelschwellenwert, so dass der Signalschwellenwert auch dann noch überschritten wird, wenn die Signalstärke durch den Regelungsvorgang verringert wurde. Damit wird die oben angegeben Aufgabe vollkommen gelöst.

Mit Blick auf Ausgestaltungen des Verfahrens ist bevorzugt, dass der Schritt der Regelung der Verstärkung einen Schritt einer Mittelung der Spitzenwerte aufweist.

Durch die Mittelung wird ein Tiefpassverhalten erzeugt, das die Regelung stabilisiert.

Aufgrund dieser Merkmale können Nutzsignale auch aus einem Primärsignal mit Rauschanteilen herausgefiltert und demoduliert werden. Im allgemeinen Fall, der sich durch ein Rauschanteile aufweisendes Primärsignal auszeichnet, erfolgt die Regelung auf sämtliche Rausch- und Datensignale und die Datensignale werden durch die digitale Filterung und Diskrimination aus dem verrauschten Signal selektiert.

Ferner ist bevorzugt, dass der Schritt der digitalen Filterung und Diskrimination Schritte eines Erfassens zeitlicher Abstände vorbestimmter Werte des Vergleichsergebnisses, Schritte eines Vergleichens der erfassten Abstände mit einem Intervall zulässiger Werte, und Schritte eines Generierens von Ausgangsimpulsen für Abstände, die in dem Intervall liegen, aufweist.

Nutzsignalanteile im Primärsignal zeichnen sich durch eine vorbestimmte Periodizität aus, während Rauschanteile zu stochastisch über einen Zeitraum verteilten Spitzenwerten führen. Dadurch, dass nur Spitzenwerte mit vorbestimmten Abständen, die der genannten Periodizität entsprechen, weiterverarbeitet werden, erfolgt eine effektive Trennung zwischen Signalanteilen und Rauschanteilen in der weiteren Signalverarbeitung. Die digitale Filterung und Diskrimination führt mit geringem schaltungstechnischen Aufwand zu einer sehr fehlertoleranten Filterung.

Eine weitere bevorzugte Ausgestaltung sieht vor, dass die Ausgangsimpulse in den Integrationsschritten integriert werden, das Integrationsergebnis mit einem ersten Integrationsschwellenwert und/oder einem zweiten Integrationsschwellenwert verglichen wird, ein Ausgangssignal bei einer Überschreitung des ersten Integrationsschwellenwerts gesetzt und bei einem Unterschreiten des zweiten Integrationsschwellenwerts zurückgesetzt wird.

Durch diese in Verbindung mit den Schwellenwertvergleichen erfolgende Integration wird ein Bild der Hüllkurve des Nutzsignalanteils im Primärsignal als Informationsgehalt des Nutzsignals ermittelt.

Bevorzugt ist auch, dass die Ausgangsimpulse vor ihrer Integration in vorbestimmter Weise verlängert werden.

Dadurch wird die Fehlertoleranz der Signalverarbeitung in erwünschter Weise erhöht, weil zum Beispiel einzelne Impulse eines Bursts im Nutzsignal fehlen können, ohne dass dies zu einer Verfälschung der ermittelten Hüllkurve führt.

Analog zu diesen Ausgestaltungen des Verfahrens ist bevorzugt, dass der Regler die Spitzenwerte unter Nachbildung eines Spitzenwertgleichrichters digital mittelt und die gemittelten Spitzenwerte als Steuersignale für den Regelverstärker bereitstellt, und/oder dass der Demodulator ein Digitalfilter mit einem Diskriminator und einem Integrator aufweist, und/oder dass der Digitalfilter mit dem Diskriminator Abstände vorbestimmter Werte des Vergleichsergebnisses ermittelt und die Abstände mit einem unteren Schwellenwert und einem oberen Schwellenwert vergleicht und einen Ausgangsimpuls generiert, wenn ein Abstand zwischen dem unteren und dem oberen Schwellenwert liegt, und/oder dass der Integrator die Ausgangsimpulse integriert und dass der Integrator ein Signal setzt, wenn das Integrationsergebnis einen ersten Integrationsschwellenwert überschreitet und zurücksetzt, wenn das Integrationsergebnis einen zweiten Integrationsschwellenwert unterschreitet, und/oder dass der Integrator seine Eingangsimpulse vor der Integration verlängert.

Diese Ausgestaltungen des Schaltkreises besitzen die bei den entsprechenden Kombinationen von Verfahrensmerkmalen aufgeführten Vorteile.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Fig. 1: ein Ausführungsbeispiel eines erfindungsgemäßen Schaltkreises;
- Fig. 2: Details eines Demodulators mit einer digitalen Filterung und Diskrimination;
- Fig. 3: zeitliche Verläufe von Bursts in einem Primärsignal vor und nach einem Regelvorgang zusammen mit relativen Lagen eines Regelschwellenwertes und verschiedener Signalschwellenwerte; und
- Fig. 4: qualitative Signalverläufe in verschiedenen Stadien einer Demodulation.

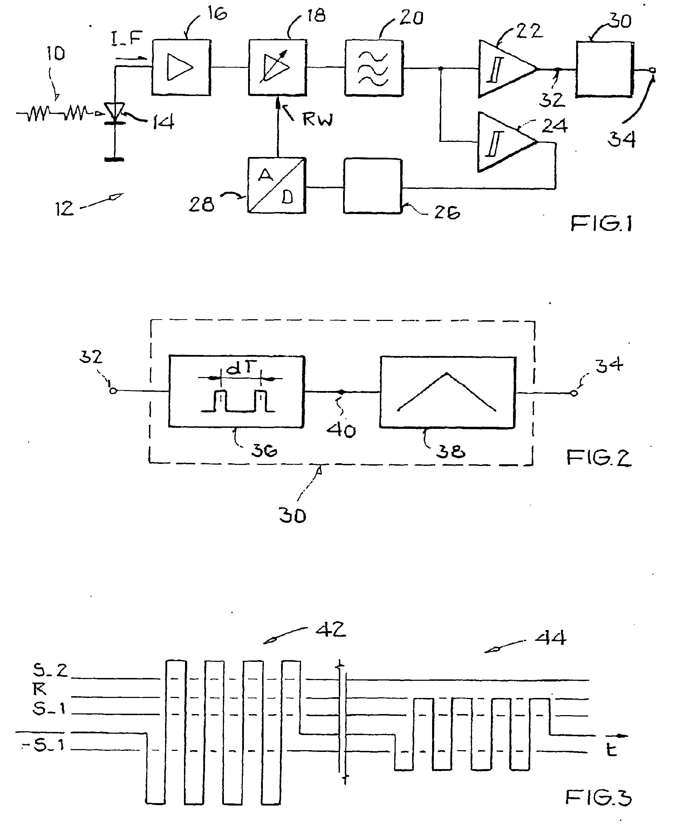

Im Einzelnen zeigt die Fig. 1 Datensignale 10, die als elektrische Primärsignale in einen Schaltkreis 12 eingespeist werden. Die Datensignale 10 können zum Beispiel Infrarot-Signale sein, die von einer Fotodiode 14 empfangen und in einen Fotostrom I_F als Beispiel eines elektrischen Signals umgewandelt werden. Typische Infrarotsignale besitzen in der Regel eine Trägerfrequenz zwischen 30 kHz und 80kHz und Pulspakete (Bursts), die durch eine Amplitudenmodulation (AM) von 100% erzeugt worden sind. Die Burst-Pakete bestehen aus mehreren Einzelimpulsen.

Die Eingangswechselströme I_F der Fotodiode 14 werden durch einen Transimpedanzverstärker 16 in Wechselspannungen umgewandelt und in einem Regelverstärker 18 abhängig von einem Regelwert RW verstärkt. Ein Bandpassfilter 20 ist auf die Trägerfrequenz abgeglichen und gewährleistet eine höhere Selektivität des Schaltkreises 12. Das Bandpassfilter 20 realisiert damit eine Vorfilterung der Signale mit ein Güte Q von typischerweise Q ungefähr gleich 2 bis 3.

Im Anschluss an die Bandpassfilterung wird das gefilterte Wechselspannungssignal durch einen Signalkomparator 22 mit einem Signalschwellenwert und durch einen Regelkomparator 24 mit einem Regelschwellenwert verglichen. Dabei liegt der Signalschwellenwert deutlich unter dem Regelschwellenwert. Wenn man dem Regelschwellenwert einen Wert von 100% zuordnet, liegt der Signalschwellenwert zum Beispiel bei + 50% und - 50%.

Ein Regler 26 verarbeitet ein Ausgangssignal des Regelkomparators 24 zu dem bereits genannten Regelwert für den Regelverstärker 18 und stellt die Verstärkung des Regelverstärkers 18 dabei so ein, dass Spitzenwerte des gefilterten Signals, also der Wechselspannung am Ausgang des Bandpassfilters 20, den Wert der Regelschwelle annehmen oder sich diesem Wert zumindest annähern.

Der Regler 26 realisiert den Regelungsvorgang bevorzugt auf digitaler Basis und bildet dabei eine schnelle Spitzenwertgleichrichtung mit Speicherkondensator nach. Dies stellt eine Ausgestaltung einer Mittelung der Spitzenwerte des gefilterten Signals dar. Ein Digital/Analog-Wandler 28 wandelt die digitale Stellgröße in einen analogen Regelwert RW, beispielsweise in einen Steuerstrom für den Regelverstärker 18, um.

Ein Demodulator 30 mit einem Eingang 32 und einem Ausgang 34 bildet aus dem Ergebnis des Vergleichs des gefilterten Signals mit dem Signalschwellenwert eine Hüllkurve des Nutzsignalanteils im Primärsignal und stellt die Hüllkurve an seinem Ausgang 34 bereit. Dazu weist der Demodulator 30 bevorzugt die in der Fig. 2 dargestellte Struktur mit einem Block 36, der ein Digitalfilter mit einem Diskriminator repräsentiert, und einem nachgeschalteten analogen Integrator 38 auf. Der Block 36 misst den Abstand zwischen zwei Signalkomparatorpulsen und selektiert die Pulse, deren Abstand in einem Zeitfenster dT liegt, das einem Intervall zulässiger Abstände entspricht. Das Zeitfenster dT stellt gewissermaßen einen von der Trägerfrequenz abhängigen Fangbereich dar. Durch den Block 36 wird mit geringem schaltungstechnischem Aufwand eine sehr steilflankige und fehlertolerante Filterung des Ausgangssignals des Signalkomparators 22 erreicht. Es wird nämlich nur dann ein Ausgangsimpuls des Blocks 36 generiert und an den Integrator 38 übergegen, wenn ein gemessener Abstand in diesem Fangbereich oder Zeitfenster dT liegt. Anschließend werden diese Ausgangsimpulse im analogen Integrator 38 integriert.

Der analoge Integrator 38 besitzt die Zustände: Laden und Entladen. Geladen wird, wenn an seinem Eingang 40 Ausgangsimpulse des Blocks 36 anliegen. Entladen wird in Pausen zwischen den Ausgangsimpulsen. In einer bevorzugten Ausgestaltung verlängert der Integrator 38 die vom Block 36 empfangenen Ausgangsimpulse. Die Verlängerung kann durch Multiplikation der Länge der Ausgangssignale des Blocks 36 mit einem Faktor von 1,6 erfolgen, wodurch das Fehlen von einzelnen Pulsen toleriert wird. Die Integrationszeit des Integrators 38 kann in einer weiteren Ausgestaltung in Abhängigkeit von der gewünschten Variante auf eine bestimmte Zahl von Impulslängen eingestellt werden, zum Beispiel auf 4 oder 7 Impulslängen. Am Ausgang 34 des Integrators 38, der gleichzeitig den Ausgang 34 des Demodulators 30 darstellt, wird ein Signal gesetzt, wenn die Summe der integrierten Ausgangsimpulse, also das Integrationsergebnis, einen ersten Integrationsschwellenwert überschreitet, der zum Beispiel bei ca. 80 % des Aussteuerbereichs des Integrators 34 liegt.

Das Setzen des Signals bildet damit den Beginn eines Bursts im Primärsignal ab. Anschließend bleibt das Signal solange gesetzt, bis das Integrationsergebnis einen zweiten Integrationsschwellenwert erreicht, der zum Beispiel einem Wert von 20 % des Aussteuerbereichs des Integrators 38 entspricht. Ein Unterschreiten des zweiten Integrationsschwellenwertes löst ein Rücksetzen des Signals aus und bildet damit das Ende eines Bursts ab. Der zeitliche Verlauf dieses gesetzten und rückgesetzten Signals stellt damit ein Bild der Hüllkurve von Bursts im Primärsignal dar. Durch die Beschränkung der Integrationszeit des Integrators 38 auf wenige Impulslängen erfolgt ein Rücksetzen auch dann schnell, wenn z.B. 30 Impulse integriert wurden.

Die Fig. 3 zeigt qualitativ Verläufe von Bursts 42, 44 in einem gefilterten Signal am Eingang des Regelkomparators 24 aus der Fig. 1 vor und nach einem Regelvorgang zusammen mit relativen Lagen eines Regelschwellenwertes R und Signalschwellenwerten S_1, -S_1, S_2. Dabei entspricht der Burst 42 einem Zustand vor einem Regelvorgang, wie er zum Beispiel beim Einschalten eines Datensenders in der Nähe eines IR-Receivers auftritt. Die Amplituden des Bursts 42 sind so hoch, dass sie den Regelschwellenwert R überschreiten. Der Schaltkreis 12 reduziert dann die Verstärkung soweit, dass die Spitzenwerte des gefilterten Signals am Eingang des Regelkomparators 24 den Wert der Regelschwelle R annehmen, wie es beim Burst 44 der Fall ist. Der im Rahmen der vorliegenden Erfindung verwendete Signalschwellenwert S_1, -S_1 ist kleiner als der Regelschwellenwert R, so dass auch die Einzelimpulse des Bursts 44 bei eingeschwungener Regelung detektiert werden. Dagegen ist der beim Stand der Technik verwendete Regelschwellenwert S_2 so groß, dass die Einzelimpulse im Burst 44 nicht mehr detektiert werden.

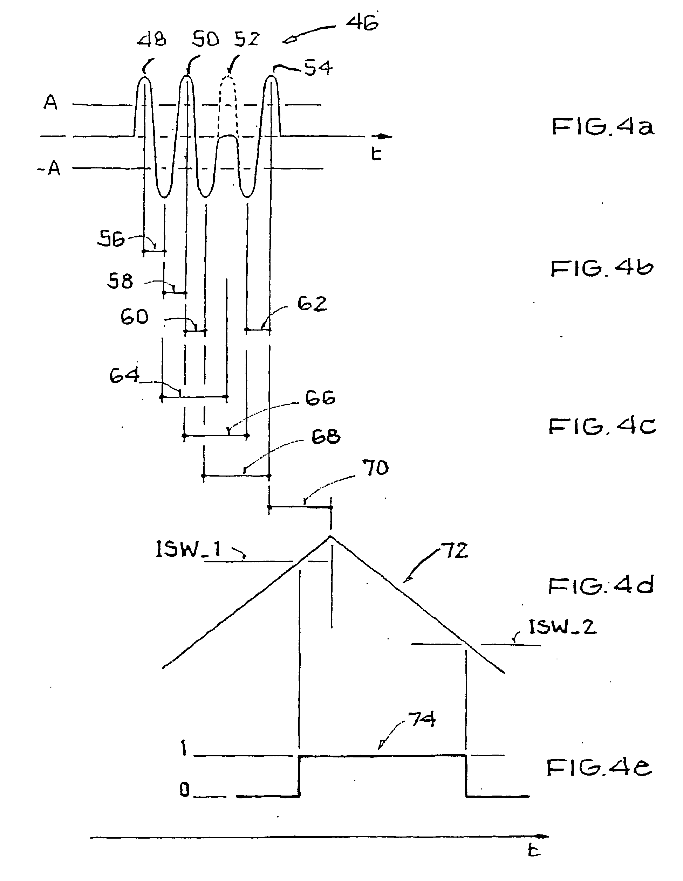

Fig. 4 zeigt qualitativ Signalverläufe in verschiedenen Stadien einer Demodulation jeweils über der Zeit t. Die Impulsfolge 46 der Fig. 4a repräsentiert qualitativ ein Ergebnis des Vergleichs des Bandpass-gefilterten Signals mit Schwellenwerten +/- S_1 und liegt am Eingang des Blocks 36 aus der Fig. 2 an. Das dargestellte Ergebnis weist drei Impulse 48, 50, 54 auf, wobei ein einzelner gestrichelt dargestellter Impuls 52 an sich vorhanden sein sollte, durch Fehler des Senders oder Empfängers aber fehlt.

Der Block 36 misst die Abstände vorbestimmter Werte des Vergleichsergebnisses, wobei die Werte eine Mindestamplitude +/- A überschreiten oder unterschreiten.. Zum Beispiel kann jeweils der Abstand 56, 58, 60, 62 erfasst werden, in dem ein Minimum auf ein Maximum, sowie ein Maximum auf ein Minimum folgt. Diese Abstände sind in der Fig. 4b dargestellt. Für jeden Abstand 56, 58, 60, 62, der innerhalb des Zeitfensters dT liegt, wird ein Impuls 64, 66, 68, 70 vorbestimmter Länge generiert, der bevorzugt größer als die Periodendauer der Impulsfolge 46 ist. In einer Ausgestaltung besitzt ein Vergrößerungsfaktor den Wert 1,6, so dass bei der Überlagerung der generierten Impulse das Fehlen des einzelnen Pulses 52 kompensiert wird. Alternativ können auch zunächst Impulse mit der Länge der Abstände generiert werden und anschließend mit einem entsprechend angepassten Faktor verlängert werden. Die Längen 64, 66, 68, 70 der verlängerten Impulse sind in der Fig. 4c dargestellt.

Anschließend erfolgt eine Integration der überlagerten Längen oder Impulse 64, 66, 68, 70 durch den Integrator 38. Der resultierende Wert 72 des Integrals ist in der Fig. 4d dargestellt. Am Ausgang 34 des Integrators 38 wird ein Signal 74 auf einen vorbestimmten Wert gesetzt (z.B. eine logische 1), wenn das Integrationsergebnis 72 einen ersten Integrationsschwellenwert ISW_1 überschreitet und zurückgesetzt (z.B. auf eine logische 0), wenn das Integrationsergebnis einen zweiten Integrationsschwellenwert ISW_2 unterschreitet. Der erste Schwellenwert ISW_1 kann zum Beispiel bei 80 % des Aussteuerbereichs des Integrators liegen und der zweite Schwellenwert ISW_2 kann zum Beispiel bei 20 % des Aussteuerbereichs liegen. Der Verlauf des Signals 74 am Ausgang des Integrators stellt daher ein Bild der Hüllkurve der Impulse 48, 50, 52, 54 eines Bursts 46 dar.

## Patentansprüche

1. Verfahren zur Verstärkung und Demodulation amplitudenmodulierter Signale (10) mit den Schritten:
- Verstärken eines Primärsignals zu einem verstärkten Signal,
- Bandpassfiltern des verstärkten Signals zu einem gefilterten Signal,
- Vergleichen des gefilterten Signals mit einem Regelschwellenwert (R) und
- Regeln der Verstärkung des Primärsignals so, dass sich Spitzenwerte des gefilterten Signals dem Regelschwellenwert (R) annähern,
- Vergleichen des gefilterten Signals mit einem Signalschwellenwert (S_1,-S_1) und Demodulieren des Vergleichsergebnisses, *wobei* der Signalschwellenwert (S_1, -S_1) kleiner als der Regelschwellenwert (R) ist,
***dadurch gekennzeichnet, dass***
*der Schritt der Demodulation Schritte einer digitalen Filterung mit Diskrimination und Integrationsschritte aufweist.*

2. Verfahren nach Anspruch 1, **dadurch gekennzeichnet, dass** der Schritt der Regelung der Verstärkung einen Schritt einer Mittelung der Spitzenwerte aufweist.

3. Verfahren *nach einem der vorhergehenden Ansprüche,* **dadurch gekennzeichnet, dass** der Schritt der digitalen Filterung und Diskrimination Schritte eines Erfassens zeitlicher Abstände (56, 58, 60, 62) vorbestimmter Werte des Vergleichsergebnisses, Schritte eines Vergleichens der erfassten Abstände (56, 58, 60, 62) mit einem Intervall zulässiger Werte, und Schritte eines Generierens von Ausgangsimpulsen (64, 66, 68, 70) für Abstände (56, 58, 60, 62), die in dem Intervall dT liegen, aufweist.

4. Verfahren nach Anspruch 3, **dadurch gekennzeichnet, dass** die Ausgangsimpulse (64, 66, 68, 70) in den Integrationsschritten integriert werden, das Integrationsergebnis (72) mit einem ersten Integrationsschwellenwert (ISW_1) und/oder einem zweiten Integrationsschwellenwert (ISW_1) verglichen wird, ein Ausgangssignal (74) bei einer Überschreitung des ersten Integrationsschwellenwerts (ISW_1) gesetzt und bei einem Unterschreiten des zweiten Integrationsschwellenwerts (ISW_2) zurückgesetzt wird.

5. Verfahren nach Anspruch 4, **dadurch gekennzeichnet, dass** die Ausgangsimpulse (64, 66, 68, 70) vor ihrer Integration in vorbestimmter Weise verlängert werden.

6. Amplitudenmodulierte Signale (10) verarbeitender Schaltkreis (12) mit
- einem Verstärker (18), der eingerichtet ist, aus einem Primärsignal ein verstärktes Signal zu erzeugen,
- einem Bandpassfilter (20), das eingerichtet ist, aus dem verstärkten Signal ein gefiltertes Signal zu erzeugen,
- einem Regelkomparator (24), der eingerichtet ist, das gefilterte Signal mit einem Regelschwellenwert (R) zu vergleichen,
- einem Regler (26), der eingerichtet ist, eine Verstärkung des Verstärkers (18) so zu regeln, dass sich Spitzenwerte des gefilterten Signals dem Regelschwellenwert (R) annähern,
- einem Signalkomparator (22), der eingerichtet ist, das gefilterte Signal mit einem Signalschwellenwert (S_1, -S_1) zu vergleichen, und
- einem Demodulator (30), der eingerichtet ist, das Vergleichsergebnis zu demodulieren, wobei der Signalschwellenwert (S_1, -S_1) kleiner als der Regelschwellenwert (R) ist,
***dadurch gekennzeichnet, dass***
*der Demodulator (30) ein Digitalfilter (36) mit einem Diskriminator und einen Integrator (38) aufweist.*

7. Schaltkreis (12) nach Anspruch 6, **dadurch gekennzeichnet, dass** der Regler (26) eingerichtet ist, die Spitzenwerte unter Nachbildung eines Spitzenwertgleichrichters digital zu mitteln und die gemittelten Spitzenwerte als Steuersignale (RW) für den Regelverstärker (18) bereit zustellen.

8. Schaltkreis (12) *nach einem der Ansprüche 7 oder 8,* **dadurch gekennzeichnet, dass** der Digitalfilter (36) eingerichtet ist, mit dem Diskiminator Abstände vorbestimmter Werte des Vergleichsergebnisses zu ermitteln und mit einem unteren Schwellenwert und einem oberen Schwellenwert zu vergleichen und einen Ausgangsimpuls (64, 66, 68, 70) zu generieren; wenn ein Abstand zwischen dem unteren und dem oberen Schwellenwert liegt.

9. Schaltkreis (12) nach Anspruch 8, **dadurch gekennzeichnet, dass** der Integrator (38) eingerichtet ist, die Ausgangsimpulse (64, 66, 68, 70) zu integrieren und dass der Integrator (38) eingerichtet ist, ein Signal zu (74) setzen, wenn das Integrationsergebnis einen ersten Integrationsschwellenwert (ISW_1) überschreitet und zurücksetzt, wenn das Integrationsergebnis einen zweiten Integrationsschwellenwert (ISW_2) unterschreitet.

10. Schaltkreis (12) nach Anspruch 9, **dadurch gekennzeichnet**, das der Integrator (38) eingerichtet ist, seine Eingangsimpulse vor der Integration zu verlängern.

## Claims

1. Method for amplification and demodulation of amplitude-modulated signals (10), comprising the steps
- amplifying a primary signal to form an amplified signal,
- subjecting the amplified signal to band-pass filtering to form a filtered signal,
- comparing the filter signal with a regulating threshold value (R),
- regulating the amplification of the primary signal so that peak values of the filtered signal approximate the regulating threshold value (R) and
- comparing the filtered signal with a signal threshold value (S_1, -S_1) and demodulating the comparison result, the signal threshold value (S_1, -S__1) being lower than the regulating threshold value (R)
**characterised in that** the step of demodulation comprises steps of digital filtering with discrimination and integration steps.

2. Method according to claim 1, **characterised in that** the step of regulation of the amplification comprises a step of averaging the peak values.

3. Method according to either one of the preceding claims, **characterised in that** the step of digital filtering and discrimination comprises steps of detection of time spacings (56, 58, 60, 62) of predetermined values of the comparison result, steps of comparison of the detected spacings (56, 58, 60, 62) with an interval of permissible values, and steps of generating output pulses (64, 66, 68, 70) for spacings (56, 58, 60. 62) lying in the interval dT.

4. Method according to claim 3, **characterised in that** the output pulses (64, 66, 68, 70) are integrated in the integration steps, the integration result (72) is compared with a first integration threshold value (ISW_1) and/or a second integration threshold value (ISW_2), an output signal (74) is set when it exceeds the first integration threshold value (ISW_1) and is restored when it falls below the second integration threshold value (ISW_2).

5. Method according to claim 4, **characterised in that** the input pulses (64, 66, 68, 70) are prolonged in predetermined manner prior to integration thereof.

6. Circuit (12) processing amplitude-modulated signals (10), comprising
- an amplifier (18) which is equipped to generate an amplified signal from a primary signal,
- a band-pass filter (20) which is equipped to generate a filtered signal from the amplified signal,
- a regulating comparator (24) which is equipped to compare the filtered signal with a regulating threshold value (R),
- a regulator (26) which is equipped to so regulate an amplification of the amplifier (18) that peak values of the filtered signal approximate the regulating threshold value (R),
- a signal comparator (22) which is equipped to compare the filtered signal with a signal threshold value (S_1, -S_1) and
- a demodulator (30) which is equipped to demodulate the comparison result, wherein the signal threshold value (S_1, -S_1) is lower than the regulating threshold value (R),
**characterised in that** the demodulator (30) is a digital filter (36) with a discriminator and a integrator (38).

7. Circuit (12) according to claim 6, **characterised in that** the regulator (26) is equipped to digitally average the peak values with simulation of a peak value rectifier and to prepare the averaged peak values as control signals (RW) for the regulating amplifier (18).

8. Circuit (12) according to one of claims 7 and 8, **characterised in that** the digital filter (36) is equipped to ascertain spacings of predetermined values of the comparison result by the discriminator and to compare them with a lower threshold value and an upper threshold value and to generate an output pulse (64, 66, 68, 70) when a spacing is present between the lower threshold value and upper threshold value.

9. Circuit (12) according to claim 8, **characterised in that** the integrator (38) is equipped to integrate the output pulses (64, 66, 68, 70) and that the integrator (38) is equipped to set a signal (74) when the integration result exceeds a first integration threshold value (ISW_1) and to restore it when the integration result falls below a second integration threshold value (ISW_2).

10. Circuit (12) according to claim 9, **characterised in that** the integrator (38) is equipped to prolong its input pulses prior to the integration.

## Revendications

1. Procédé d'amplification et de démodulation de signaux (10) modulés en amplitude comportant les étapes suivantes :
. amplification d'un signal primaire en un signal amplifié,
. filtrage passe-bande du signal amplifié en un signal filtré,
. comparaison du signal filtré à la valeur de seuil de réglage (R) et
. réglage de l'amplification du signal primaire de telle manière que des valeurs de crête du signal filtré se rapprochent de la valeur de seuil de réglage (R),
. comparaison du signal filtré à une valeur de seuil de signal (S_1, -S_1) et démodulation du résultat de la comparaison, la valeur de seuil de signal (S_1, -S_1) étant inférieure à la valeur de seuil de réglage (R),
**caractérisé en ce que**
l'étape de démodulation comprend des étapes de filtrage numérique avec des étapes de discrimination et d'intégration.

2. Procédé selon la revendication 1, **caractérisé en ce que** l'étape de réglage de l'amplification présente une étape de moyennage des valeurs de crête.

3. Procédé selon l'une quelconque des revendications précédentes, **caractérisé en ce que** l'étape de filtrage numérique et de discrimination présente des étapes d'enregistrement d'intervalles temporels (56, 58, 60, 62) de valeurs prédéfinies du résultat de la comparaison, des étapes de comparaison des intervalles enregistrés (56, 58, 60, 62) à un intervalle de valeurs admissibles, et des étapes de génération d'impulsions de sortie (64, 66, 68, 70) pour des intervalles (56, 58, 60, 62) situés dans l'intervalle de temps dT.

4. Procédé selon la revendication 3, **caractérisé en ce que** les impulsions de sortie (64, 66, 68, 70) sont intégrées au cours des étapes d'intégration, **en ce que** le résultat de l'intégration (72) est comparé à une première valeur de seuil d'intégration (ISW_1) et/ou à une deuxième valeur de seuil d'intégration (ISW_2), **en ce qu'**un signal de sortie (74) est bloqué lors d'un dépassement de la première valeur de seuil d'intégration (ISW_1) et remis à zéro lors d'un passage en-dessous de la deuxième valeur de seuil d'intégration (ISW_2).

5. Procédé selon la revendication 4, **caractérisé en ce que** les impulsions de sortie (64, 66, 68, 70) sont augmentées en durée de manière prédéfinie avant leur intégration.

6. Circuit (12) mettant en oeuvre des signaux (10) modulés en amplitude, comprenant :
. un amplificateur (18), conçu pour générer un signal amplifié à partir d'un signal primaire,
. un filtre passe-bande (20), conçu pour générer un signal filtré à partir du signal amplifié,
. un comparateur de réglage (24), conçu pour comparer le signal filtré à une valeur de seuil de réglage (R),
. un régulateur (26), conçu pour commander une amplification de l'amplificateur (18) de telle manière que des valeurs de crête du signal filtré se rapprochent de la valeur de seuil de réglage (R),
. un comparateur de signaux (22), conçu pour comparer le signal filtré à une valeur de seuil de signal (S_1, -S_1), et
. un démodulateur (30), conçu pour démoduler le résultat de la comparaison, la valeur de seuil de signal (S_1, -S_1) étant inférieure à la valeur de seuil de réglage (R),
**caractérisé en ce que** :
le démodulateur (30) présente un filtre numérique (36) comprenant un discriminateur et un intégrateur (38).

7. Circuit (12) selon la revendication 6, **caractérisé en ce que** le régulateur (26) est conçu pour le moyennage numérique des valeurs de crête par simulation d'un redresseur de valeurs de crête et pour fournir à l'amplificateur de régulation (18) des valeurs de crête moyennées comme signaux de commande (RW).

8. Circuit (12) selon l'une quelconque des revendications 7 ou 8, **caractérisé en ce que** le filtre numérique (36) est conçu pour déterminer au moyen du discriminateur des intervalles de valeurs prédéfinies du résultat de comparaison et pour les comparer à une valeur de seuil inférieure et une valeur de seuil supérieure, et pour générer une impulsion de sortie (64, 66, 68, 70) lorsqu'existe un intervalle entre la valeur de seuil inférieure et la valeur de seuil supérieure.

9. Circuit (12) selon la revendication 8, **caractérisé en ce que** l'intégrateur (38) est conçu pour intégrer les impulsions de sortie (64, 66, 68, 70) et **en ce que** l'intégrateur (38) est conçu pour bloquer un signal (74) lorsque le résultat de l'intégration dépasse une première valeur de seuil d'intégration (ISW_1) et le remettre à zéro lorsque le résultat de l'intégration se situe en-dessous d'une deuxième valeur de seuil d'intégration (ISW_2).

10. Circuit (12) selon la revendication 9, **caractérisé en ce que** l'intégrateur (38) est conçu pour augmenter la durée de ses impulsions d'entrée avant l'intégration.
